# EUROPEAN PATENT APPLICATION

(11) **EP 4 815 660 A1**
(43) Date of publication of application: **30.09.2026**
(21) Application number: 25200958.4
(22) Date of filing: 09.09.2025
(51) Int. Cl.: H10D 1/66, H10D 1/68, H10D 84/80, H10W 20/40

(54) **SEMICONDUCTOR-BASED CAPACITOR WITH VERTICAL AND LATERAL CAPACITIVE JUNCTIONS**

(30) Priority: 27.03.2025 US 202519091961
(71) Applicant: GlobalFoundries Singapore Pte. Ltd., Singapore 738406 (SG)
(72) Inventor: Khor, Ee Jan, 738406 Singapore (SG); Yi, Wanbing, 738406 Singapore (SG); See, Yong Wah, 738406 Singapore (SG); Zhang, Guowei, 738406 Singapore (SG)
(74) Representative: Grünecker Patent- und Rechtsanwälte PartG mbB

(57) **Abstract**

The disclosure relates to a semiconductor-based capacitor structure and method of forming the semiconductor-based capacitor. A structure according to the disclosure includes a semiconductor substrate including a well region. An isolation structure is in the semiconductor substrate laterally adjacent to the well region. A first dielectric layer is on the isolation structure. A first polycrystalline semiconductor layer is on the first dielectric layer. A second dielectric layer includes a first portion on the well region and at least one second portion extending vertically from the first portion. A second polycrystalline semiconductor layer is on the first portion of the second dielectric layer. The second portion of the second dielectric layer is laterally between and immediately adjacent to the second polycrystalline semiconductor layer and the first polycrystalline semiconductor layer.

## Description

### BACKGROUND

The present disclosure relates to semiconductor structures and, more particularly, to a semiconductor-based capacitor structure and method of forming the semiconductor-based capacitor.

Planar metal oxide semiconductor capacitors (MOSCAPS) are readily integrated into complementary metal oxide semiconductor (CMOS) processing technologies. A simple planar MOSCAP can include a well region within a semiconductor substrate as a first capacitor electrode, a dielectric layer on the top surface of the semiconductor substrate as a capacitor dielectric and a doped polycrystalline semiconductor layer on the dielectric layer as the second capacitor electrode. However, to achieve the required amount of capacitance for some applications relatively large planar MOSCAPs that consume a significant amount of area are required. While techniques for developing higher density MOSCAPs have been developed such techniques typically involve complex processing (e.g., using multiple masks).

### SUMMARY

All aspects, examples and features mentioned below can be combined in any technically possible way.

An aspect of the disclosure provides a structure including: a semiconductor substrate including a well region; an isolation structure in the semiconductor substrate laterally adjacent to the well region; a first dielectric layer on the isolation structure; a first polycrystalline semiconductor layer on the first dielectric layer; a second dielectric layer including a first portion on the well region and at least one second portion extending vertically from the first portion; and a second polycrystalline semiconductor layer on the first portion of the second dielectric layer, wherein the second portion of the second dielectric layer is laterally between and immediately adjacent to the second polycrystalline semiconductor layer and the first polycrystalline semiconductor layer.

An aspect of the disclosure includes a structure, including: a semiconductor substrate including a plurality of well regions; a plurality of isolation structures in the semiconductor substrate on opposing sides of at least one of the plurality of well regions; on each isolation structure, a first dielectric layer on the isolation structure and a first polycrystalline semiconductor layer on the first dielectric layer; and on each well region, a second dielectric layer including a first portion on the well region and second portions extending vertically from the first portion and a second polycrystalline semiconductor layer on the first portion laterally between and adjacent to the second portions, wherein each second portion is further laterally between and adjacent one first polycrystalline semiconductor layer and one second polycrystalline semiconductor layer.

An aspect of the disclosure includes a method, including: forming a well region in a semiconductor substrate; forming an isolation structure in the semiconductor substrate laterally adjacent to the well region; forming a first dielectric layer on the isolation structure; forming a first polycrystalline semiconductor layer on the first dielectric layer; forming a second dielectric layer including a first portion on the well region and at least one second portion extending vertically from the first portion; and forming a second polycrystalline semiconductor layer on the first portion of the second dielectric layer, wherein the second portion of the second dielectric layer is positioned laterally between and immediately adjacent to the second polycrystalline semiconductor layer and the first polycrystalline semiconductor layer.

Two or more aspects described in this disclosure, including those described in this summary section, may be combined to form implementations not specifically described herein.

The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a first cross-sectional view of a structure according to embodiments of the disclosure.
FIG. 2 shows a second cross-sectional view of a structure according to embodiments of the disclosure.
FIG. 3 shows a cross-sectional view of a structure according to the disclosure, annotated with capacitive junctions and example voltage polarities.
FIG. 4 shows a cross-sectional view of a structure and field effect transistor (FET) according to embodiments of the disclosure.
FIGS. 5-10 depicts processes of forming a structure according to embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (a) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Planar metal oxide semiconductor capacitors (MOSCAPS) are readily integrated into complementary metal oxide semiconductor (CMOS) processing technologies. A simple planar MOSCAP can include a well region within a semiconductor substrate as a first capacitor electrode, a dielectric layer on the top surface of the semiconductor substrate as a capacitor dielectric and a doped polycrystalline semiconductor layer on the dielectric layer as the second capacitor electrode. However, to achieve the required amount of capacitance for some applications relatively large planar MOSCAPs that consume a significant amount of area are required. While techniques for developing higher density MOSCAPs have been developed such techniques typically involve complex processing (e.g., using multiple masks).

The disclosure relates to semiconductor-based capacitor structures and methods for forming a semiconductor-based capacitor with lateral and vertical capacitive junctions for increased capacitance density. For purposes of this disclosure, a high-density capacitor refers to a capacitor designed to create a relatively large amount of capacitance within a relatively small area of a chip. A structure according to the disclosure includes a semiconductor substrate including a well region. An isolation structure is in the semiconductor substrate laterally adjacent to the well region. A first dielectric layer is on the isolation structure. A first polycrystalline semiconductor layer is on the first dielectric layer. A second dielectric layer includes a first portion on the well region and at least one second portion extending vertically from the first portion. A second polycrystalline semiconductor layer is on the first portion of the second dielectric layer. The second portion of the second dielectric layer is laterally between and immediately adjacent to the second polycrystalline semiconductor layer and the first polycrystalline semiconductor layer.

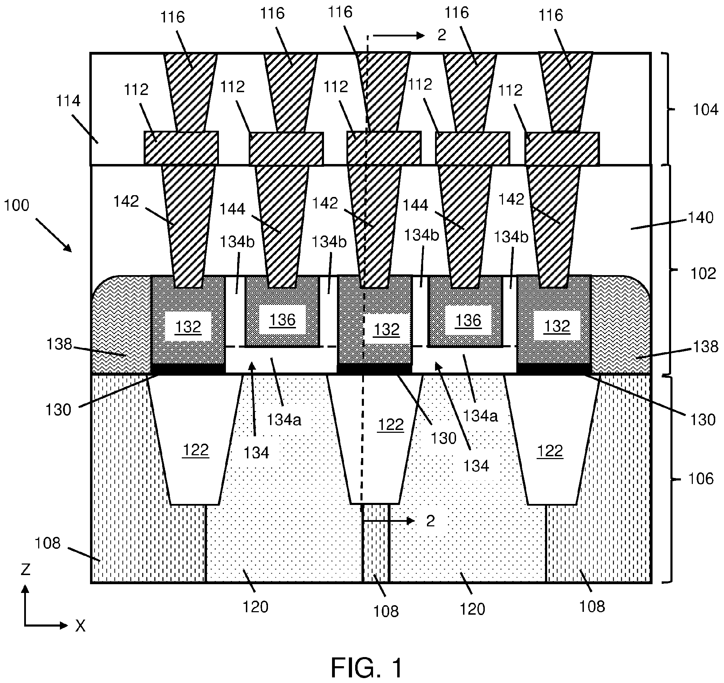

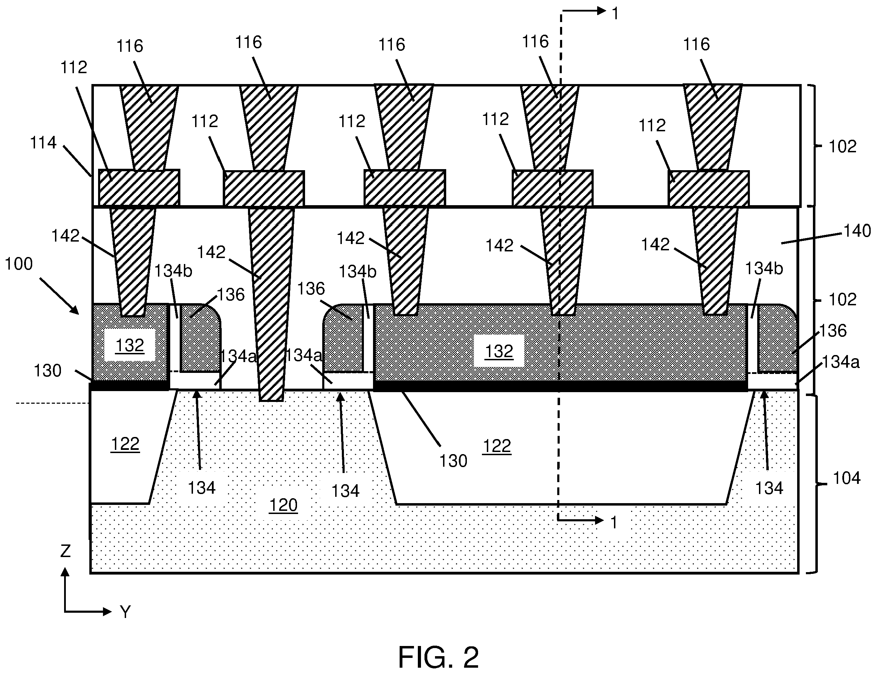

Referring to FIGS. 1 and 2, in which FIG. 1 provides a first cross-sectional view in plane X-Y and FIG. 2 provides a second cross-sectional view in plane X-Z, an example of a structure 100 according to embodiments of the disclosure is provided. The perspective of FIG. 2 is indicated by view line 2-2 in FIG. 1 and the perspective of FIG. 1 is indicated by view line 1-1 in FIG. 2. Semiconductor-based capacitor 100 (hereinafter referred to as structure 100) is a capacitor in which features of both metal oxide semiconductor capacitors (MOSCAPs) and polycrystalline semiconductor-insulator-polycrystalline semiconductor capacitors (PIPCAPs) are integrated and physically arranged to provide vertical capacitive junctions and lateral capacitive junctions between electrodes for increased capacitance density. Structure 100 may be partially within, e.g., in a local interconnect (also known as "middle of line" or "MOL") layer 102 vertically between a metal wiring layer (also known as "back end of line" (BEOL) layer) 104 of a device and over a device layer 106 having a semiconductor substrate 108 (e.g., monocrystalline semiconductor materials such as silicon (Si), silicon germanium (SiGe), etc.). Metal wiring layer 104 may include a plurality of wires 112 (shown, e.g., one row of wires 112, five shown in the visible area) within an insulator layer 114. Insulator layer 114 may include any currently known or later developed insulative substance, including for instance oxide-based insulators (e.g., various silicon oxide compounds), nitride based insulators, and/or other insulative materials particularly those having a dielectric constant of less than approximately 3.9.

Insulator layer 114 may include one or more distinct layers of an inter-level dielectric (ILD) material, each for separating different wires 112 from each other. In this case, portions of insulator layer 114 may include etch stop layers (ESL) (not separately shown) along the upper and/or lower surface of each layer. Although insulator layer 114 is not metallic, it is considered part of metal wiring layer 104. ESL materials within insulator layer 114 may include, e.g., any material distinct from other insulator(s) therein and having greater resistance to etching, to structurally distinguish between vertically adjacent wiring layers. ESLs may be formed separately from other parts of insulator layer 114 and may be formed in a variety of configurations for additional electrical and physical separation between electrically active conductive materials.

Each wire 112 within insulator layer 114 may include any currently known or later developed conductive metal suitable to accumulate charge across a dielectric junction. Wires 112, in one example, may include silicon-based conductor materials or other doped semiconductor conductive materials (e.g., doped Si or silicon germanium (SiGe), metals such aluminum, (Al), copper (Cu), zinc (Zn), gold (Au), and/or other conductive materials) capable of operating as a capacitor terminal. In further embodiments, wires 112 may include one or more metals, e.g., tungsten (W), titanium (Ti), ruthenium (Ru), cobalt (Co), copper (Cu), aluminum (Al), etc. Wires 112 may be formed by depositing conductive materials on an underlying layer (e.g., another layer of insulator) e.g., insulator layer 114 is formed thereon. Wires 112 in different positions may be electrically decoupled from each other, e.g., they may be isolated from each other by portions of insulator layer 114. Multiple wires 112 may be present in structure 100 to provide alternating polarity terminals of distinct capacitive junctions as discussed herein.

Metal wiring layer 104 also includes a set of vias 116, each connecting respective vertically aligned pairs of wires 112. Vias 116 alternatively may be in a variety of additional and/or alternative locations to those shown in FIG. 1 *et seq.* Each via 116 may extend vertically through insulator layer 114 completely between wires 112 and other vertically aligned wires (not shown) to provide an electrical pathway through insulator layer 114, and in some cases, wires 112 may horizontally connect two or more vias 116 located in different areas (e.g., different cross-sections) of metal wiring layers 104. Vias 116 are shown in an example to connect vertically aligned wires 112 of all rows together, but this is not required in all implementations.

Within device layer 106, portions of substrate 108 may be doped to define a set of well regions 120. Well regions 120 may have any conceivable doping type (P-type or N-type to denote different conductivity types) and/or doping composition appropriate for use within substrate 108 to create electrically conductive regions therein. Where substrate 108 includes silicon, well regions 120 may be doped with Phosphorus (P), Arsenic (As), and/or Antimony (Sb) to provide N-type conductivity or may be doped with Boron (B), Aluminum (Al), and Gallium (Ga) to provide P-type conductivity. Regardless of which dopants and/or conductivities are used within well regions 120, well regions 120 may be of higher conductivity than substrate 108. Device layer 106 also includes a set of isolation structures 122 each adjacent respective well region(s) 120. Isolation structures 122, also known as trench isolations (TIs), may be formed by removing portions of semiconductor material from substrate 108 to form trenches and depositing insulative material(s) within the trenches. According to an example, isolation structures 122 may be one or more oxide-based insulators (e.g., silicon dioxide (SiO₂) and/or other combinations of silicon and oxygen in different proportions), or other materials having similar properties. Three well regions 120 and two isolation structures 122 are illustrated in FIG. 1 but any number of well regions 120 and isolation structures 122 may be provided.

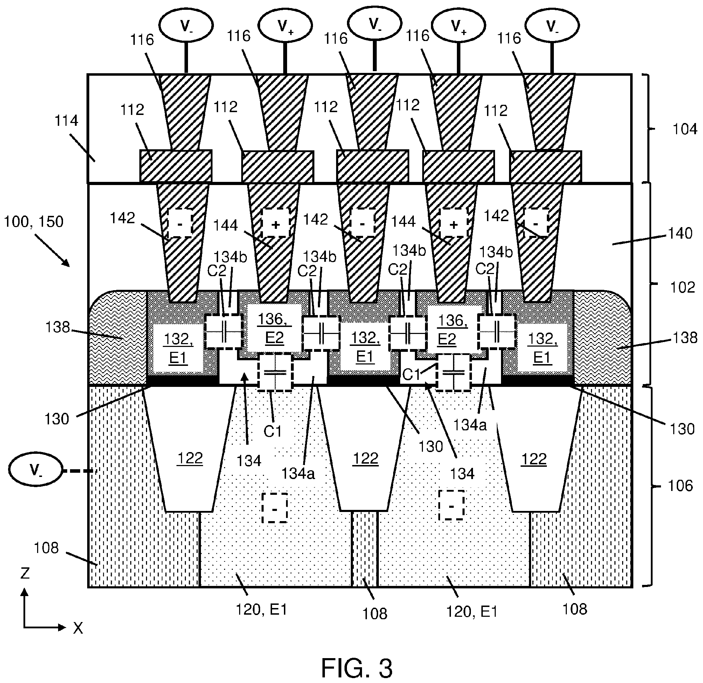

Within local interconnect layer 104, structure 100 is configured to vertically couple doped well(s) 120 of device layer 106 to metal wire(s) 112 of metal wiring layer 104 through sets of vertically oriented and horizontally oriented capacitive junctions (i.e., capacitive junctions C1, C2 shown in FIG. 3). Further details of capacitive junctions C1, C2 are discussed in further detail elsewhere herein. Structure 100 includes one or more first dielectric layers 130, each on one of isolation structures 122. Each first dielectric layer 130 may include, e.g., a gate dielectric material having a dielectric constant of at least approximately 3.9, or alternatively, a dielectric constant higher than that of isolation structures 122. Materials appropriate for use as, or within, first dielectric layers 130 may include (without limitation): hafnium dioxide (HfO2), zirconium dioxide (ZrO2), aluminum oxide (Al2O3), and silicate derivatives of these materials (e.g., hafnium silicon oxide (HfSiO4), zirconium silicon oxide (ZrSiO4) etc.). First dielectric layers 130 may be formed during the same phases of processing to form date dielectric layers elsewhere on device layer 106, and thus, first dielectric layers 130 may have a thickness of between approximately 2.0 and approximately 3.5 nanometers over device layer 106.

Structure 100 also includes first polycrystalline semiconductor layer(s) 132 on the first dielectric layer(s) 130 on the isolation structure(s) 122. First polycrystalline semiconductor layer 132 may include, e.g., polycrystalline silicon (Si), silicon germanium (SiGe), and/or other semiconductor material(s) doped to have a desired conductivity type. During operation, first polycrystalline semiconductor layers 132 may have a same conductivity type as well regions 120 and thus may have the same voltage polarity. First polycrystalline semiconductor layers 132 may be formed by deposition of polycrystalline semiconductor layer(s) by epitaxial growth, and subsequent processing (e.g., targeted etching of the deposited layer(s)) to form first polycrystalline semiconductor layers 132 in distinct horizontally separated areas. First polycrystalline semiconductor layers 132 may be similar in shape and size, as shown in FIG. 1, or may be in a variety of other configurations. As specifically shown in FIG. 2, first polycrystalline semiconductor layer(s) 132 may extend laterally in front of and behind the X-Z plane shown in FIG. 1.

Structure 100 includes a second dielectric layer 134 on well region 120. Second dielectric layer 134 may have a same composition or similar composition to isolation structures 122, e.g., second dielectric layer 134 may include silicon dioxide and/or other electrical insulators derived from silicon or other semiconductor materials combined with oxide, nitride, etc. Second dielectric layer 134 may have a lower dielectric constant than first dielectric layer 130, and thus, dielectric layers 130, 134 each may include different dielectric materials. A first portion 134a of second dielectric layer 134 may be on device layer 106 (e.g., and particularly aligned over a well region 120 thereof), and may be horizontally adjacent first dielectric layer 130 and a portion of first polycrystalline semiconductor layer 132 thereover. Second dielectric layer 134 also includes a set of (i.e., one or more) second portions 134b extending vertically upward from first portion 134a. Second portions 134b are distinguished from first portions 134a in FIG. 1 with dashed lines solely for ease of explanation. Portions 134a, 134b may be compositionally identical and free of physical interfaces therebetween. Two second portions 134b are shown on each first portion 134a of second dielectric layer 134 as an example in FIG. 1, but this is not required in all implementations. Second dielectric layer 134 thus may be substantially U-shaped in some implementations, such as in the cross-section shown in FIG. 1, or more generally may have a scyphoid geometry (i.e., cup shape) to provide horizontally oriented and vertically oriented insulative barriers over well region 120 and adjacent first polycrystalline semiconductor layer(s) 132. Second dielectric layer 134 also may extend horizontally in front of, and beyond, first polycrystalline semiconductor layer 132, e.g., as shown in FIG. 2.

Structure 100 includes one or more second polycrystalline semiconductor layers 136 on first portion 134a of second dielectric layer 134. Second polycrystalline semiconductor layers 136 may be compositionally similar or identical to first polycrystalline semiconductor layers 132 (e.g., layers 136 also may include polycrystalline Si, SiGe, etc.). Second polycrystalline semiconductor layers 136 may include different dopants therein to provide a different conductivity type from first polycrystalline semiconductor layers 132. Where second dielectric layer 134 includes two second portions 134b, second polycrystalline semiconductor layer 136 may be laterally between and adjacent the two second portions 134b of second dielectric layer 134.

As illustrated, first portion 134a of second dielectric layer 134 may have a larger vertical thickness than first dielectric layer 130. First dielectric layer 130 may be thinner than second dielectric layer 134, without regard to portions 134a, 134b thereof. Second polycrystalline semiconductor layers 136 may have a smaller vertical thickness than first polycrystalline semiconductor layers 132. All polycrystalline semiconductor layers 132, 136 and second portions 134b of second dielectric layer 134 optionally may have upper surfaces that are substantially coplanar with each other, and layers 132, 136 and second dielectric layer 134 may have different depths relative to their upper surfaces. Second dielectric layer 134 also may physically separate first polycrystalline semiconductor layers 132 from horizontally adjacent second polycrystalline semiconductor layers 136 forward of and/or behind the X-Z cross-section shown as indicated in FIG. 2.

First portion 134a vertically separates one well region 120 from one second polycrystalline semiconductor layer 136 thereover. Second portion 134b, extending vertically from first portion 134a, similarly provides an insulative barrier between polycrystalline semiconductor layers 132, 136. Second portion 134b of second dielectric layer 134 in particular may be laterally between and immediately adjacent to first polycrystalline semiconductor layer 132 and second polycrystalline semiconductor layer 136. Second dielectric layer 134 may be the only physical structure horizontally separating second polycrystalline semiconductor layer 136 from its adjacent first polycrystalline semiconductor layers 136. Second dielectric layer 134 similarly may be the only physical structure vertically separating second polycrystalline semiconductor layer 136 from doped region 120 of substrate 108 thereunder.

Structure 100 may include a sidewall spacer 138 (FIG. 1 only) laterally adjacent first dielectric layer 130 and polycrystalline semiconductor layer 132 thereon. First dielectric layer(s) 130 and polycrystalline semiconductor layer(s) 132 adjacent sidewall spacer 138 may be the horizontally outermost layer(s) 130, 132 of structure 100. Sidewall spacer 138 alternatively may be alongside second dielectric layer 134 and/or second polycrystalline semiconductor layer 136. Sidewall spacer 138 may include multiple spacer materials, e.g., it may include one or more inner spacer layers and one or more outer spacer layers, but these materials are not shown solely for clarity of illustration. Sidewall spacer 138 thus may include any currently known or later developed insulative material(s), such as oxide-based and/or nitride based insulators, in any number or arrangement of layers. Where sidewall spacer 138 includes multiple layers, each layer optionally may have a different dielectric constant and thus may provide a distinct amount of electrical isolation. However embodied, sidewall spacers 138 may be included on outer horizontal ends of structure 100 to control (e.g., increase) the electrical insulation between active materials within structure 100 and other active materials located elsewhere within MOL layer 102.

An inter-level dielectric (ILD) layer 140 may be within MOL layer 102 and over structure 100. ILD layer 140 may include the same insulating material as isolation structures 122 or may include a different electrically insulative material for vertically separating active materials from overlying materials, e.g., various horizontally extending wires or vias. ILD layer 140 and isolation structures 122 nonetheless constitute different components, e.g., due to isolation structures 122 being above device layer 106 whereas isolation structures 122 are formed separately and embedded within substrate 108. ILD layer 140 may be formed by deposition and/or other techniques to provide electrically insulating materials, and can then be planarized (e.g., using chemical mechanical planarization (CMP)), such that its upper surface remains above any active components of structure 100. One or more barrier layers (not shown) including, e.g., nitride-based dielectric materials (such as silicon nitride (SiN)) may be on ILD layer 140 to further separate MOL layer 102 from overlying materials and/or to enable certain portions of structure 100 to be formed and processed differently from each other to affect the location of conductive terminals for a capacitor.

Structure 100 includes several contacts to polycrystalline semiconductor layers 132, 136 of structure 100. A set of first contacts 142 may electrically couple selected metal wires 112 of metal wiring layer 104 to doped regions 120 (FIG. 2 only) and first polycrystalline semiconductor layers 132. A set of second contacts 144 may electrically couple other selected metal wires 112 of metal wiring layer 104 to second polycrystalline semiconductor layers 136. Contacts 142, 144 connected to polycrystalline semiconductor layers 132, 136 optionally may be similar or identical in size. First contacts 142 to doped regions 120 may be larger than first contacts to first polycrystalline semiconductor layers 132 but are still referred to as first contacts 142 herein by having the same voltage polarity. In some cases, first contacts 142 may be distinguished from second contacts 144 by being on first polycrystalline semiconductor layers 132 or doped regions 120 as opposed to second polycrystalline semiconductor layers 136. In other cases, e.g., where layers 132, 136 do not have substantially coplanar upper surfaces, contacts 142, 144 may be differentiable based on their vertical depths relative to metal wiring layer 104.

Contacts 142, 144 (and any other vertically oriented conductive materials discussed herein, e.g., vias 116) each may include refractory metal liners (not shown for simplicity of illustration) including, for example, ruthenium (Ru), tantalum (Ta), titanium (Ti), tungsten (W), iridium (Ir), rhodium (Rh) and platinum (Pt), etc., or mixtures of thereof. Vias 116, contacts 142, 144, etc., also may include other types of conductive materials, e.g., conductive nitride compounds (TaN, TiN, etc.).

Referring now to FIGS. 1-3 together, structure 100 during operation may function as a capacitor 150 due to the arrangement and position of doped region 120 and layers 130, 132, 134, 136 when contacts 142, 144 are coupled to respective voltages. Capacitor 150 may include first electrodes E1 defined within first polycrystalline semiconductor layer 132 and doped region 120. First electrodes E1 each may have a same voltage polarity. In FIG. 3, first polycrystalline semiconductor layer 132 is coupled to a negative voltage through first contact 142 and metal wiring layer 104 and electrodes E1, in this example, each have a negative voltage. Doped regions 120 similarly may be coupled to a negative voltage, e.g., through first contact(s) 142 to doped region 120 located horizontally away from substrate 108, as shown in FIG. 2 and schematically indicated with dashed lines in FIG. 3. Capacitor 150 also may include second electrodes E2 defined within second polycrystalline semiconductor layer 136. Second electrodes E2 each may have a same voltage polarity. In this example, second polycrystalline semiconductor layer 136 is coupled to a positive voltage through second contact 142 and metal wiring layer 104 and electrodes E2 each have a positive voltage. This arrangement of electrodes and capacitive junctions provides a set of horizontally oriented and vertically oriented capacitive junctions to increase capacitive density relative to other capacitor architectures.

During operation, second dielectric layer 134 (including first portion 134a and second portion 134b thereof) may have a sufficiently low dielectric constant and/or vertical thickness for a first capacitive junction C1 to be formed across the vertical interface between doped well 120 (one first electrode E1) and second dielectric layer 136 (one second electrode E2), i.e., across first portion 134a. A second capacitive junction C2 similarly is formed across the horizontal interface between polycrystalline semiconductor layers 132, 136 (horizontally aligned pairs of first electrodes E1 and second electrodes E2), i.e., across second portions 134b. The accumulation of charge may arise from voltages applied to layers 132, 136 and doped region 120 when metal wiring layer 104 and device layer 106 are coupled to positive and negative voltages, such as where indicated in FIG. 2. Structure 100 is thus configured to provide the structure and function of multiple capacitive junctions via first capacitive junction C1 and second capacitive junction C2 within one capacitor 150.

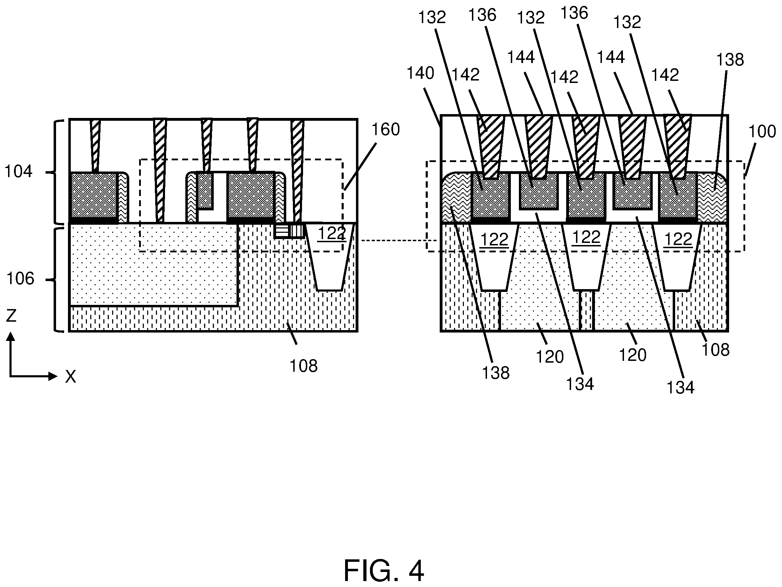

Referring briefly to FIGS. 1 and 4 together, embodiments of structure 100 are also capable of being formed and implemented together with other structures formed on device layer 106 and within MOL layer 102. Reference lines for some subcomponents within structure 100 are omitted in FIG. 4 solely for clarity of illustration, and structure 100 where shown in FIG. 3 may be implemented according to any embodiment of structure 100 discussed herein. Two portions of a device on one substrate 108 are shown in FIG. 4, with dashed lines indicating an indeterminate distance between two locations.

Structure 100 may be located on substrate 108 in one location, and a field effect transistor (FET) 160 may be located elsewhere on substrate 108. At least one isolation structure 122 may electrically isolate structure 100 from FET 160. FET 160 is shown by example to be a low diffusion metal oxide field effect transistor (LDMOSFET) device including a gate, source terminal, drain terminal, and field plate, but any conceivable FET architecture may be implemented. Moreover, FET 160 may be replaced with any other device capable of being formed in device layer 106, e.g., a bipolar junction transistor (BJT), inductor, resistor, or other capacitors implemented via embodiments of structure 100 and/or other device architectures. As discussed herein, structure 100 may be formed by adaptation and/or implementation of process steps used to from FET 160 or other devices elsewhere on substrate 108.

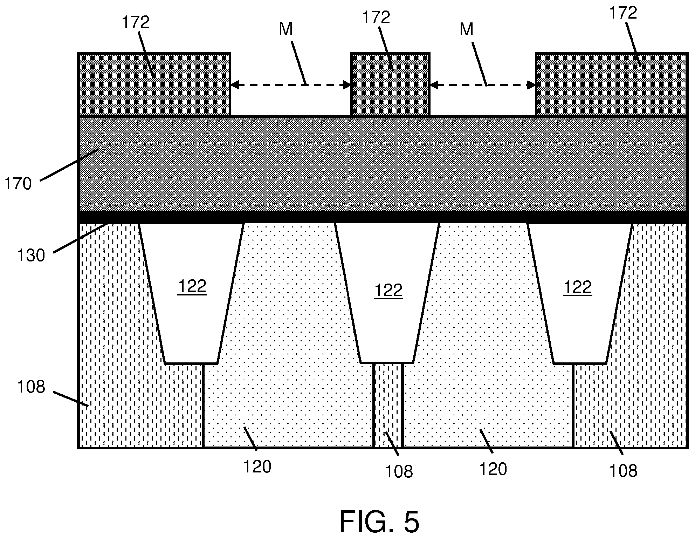

Referring now to FIG. 5, examples of methods to form structure 100 (FIGS. 1-4) according to the disclosure are discussed. Embodiments of structure 100 are easily integrated into conventional processing techniques to form other components on and/or within layers 102, 104, 106 by using one or more processes to form transistors, gates, etc., elsewhere on device layer 106 to form structure 100 and capacitive junctions C1, C2 (FIG. 3) thereof. Initially, substrate 108 may include well region(s) 120 and one or more isolation structures 122 for electrically separating different well regions 120 from each other and/or from other structures formed on substrate 108. Substrate 108 may include one or more monocrystalline semiconductor materials as discussed herein. Isolation structures 122 may include one or more insulator materials (e.g., various oxide-based insulators) and may be formed by forming trenches within substrate 108 filling the trenches with insulator, and planarizing the insulator (e.g., by chemical mechanical planarization (CMP)) to yield isolation structures 122.

Initial phases of processing also may include, e.g., forming first dielectric layer 130 as a single layer to cover substrate 108, well regions 120, and isolation structures 122. First dielectric layer 130 may include a gate dielectric material as discussed elsewhere herein and thus may be of lower thickness than other layers on substrate 108. The disclosure includes forming a first precursor polycrystalline semiconductor layer (simply "first precursor layer" hereafter) 170 on first dielectric layer 130. First precursor layer 170 may be formed by deposition and/or epitaxial growth. The presence of first dielectric layer 130 over substrate 108 will prevent crystalline orientation(s) of substrate 108, well regions 120, etc., from being replicated in first precursor layer 170, and thus first precursor layer 170 may have a polycrystalline structure. First precursor layer 170 also may be doped *in situ* to have a desired conductivity type after being formed. Continued processing includes forming a first mask 172 on first precursor layer 170. First mask 172 may include a photoresist layer and/or other material shaped for targeted etching of first precursor layer 170 in selected locations. As shown, first mask 172 may include a set of openings M each located over of doped regions 120 and horizontally between the locations of isolation structures 122. First mask 172 is thus shaped to enable converting of first precursor layer 170 into first polycrystalline semiconductor layers 132 (FIGS. 1-4), to enable subsequent forming of second polycrystalline semiconductor layers 136 (FIGS. 1-4).

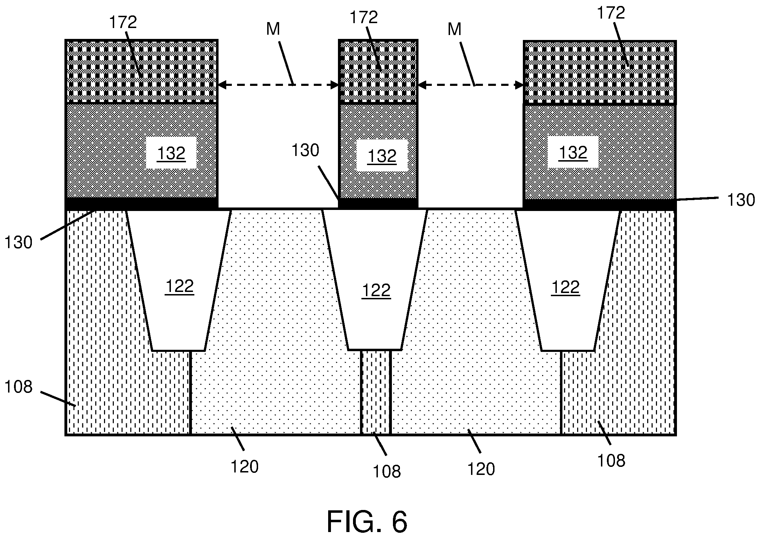

FIG. 6 depicts removing portions of first precursor layer 170 (FIG. 5) using first mask 172. The partial removing of first precursor layer 170 may include non-selective etching (e.g., vertically oriented reactive ion etching (RIE)) to remove all portions of first precursor layer 170, and underlying portions of first dielectric layer 130, located within openings M. The partial removing of first precursor layer 170 may expose upper surfaces of well regions 120, and optionally, adjacent upper surfaces of isolation structures 122. Well regions 120 and isolation structures 122 may remain substantially intact may controlling the etching time and/or composition no of etchants. Remaining areas of first precursor layer 170 create first polycrystalline semiconductor layers 132 with openings M horizontally therebetween. First mask 172 then may be removed by stripping and/or other currently known or later developed techniques to remove masking material(s).

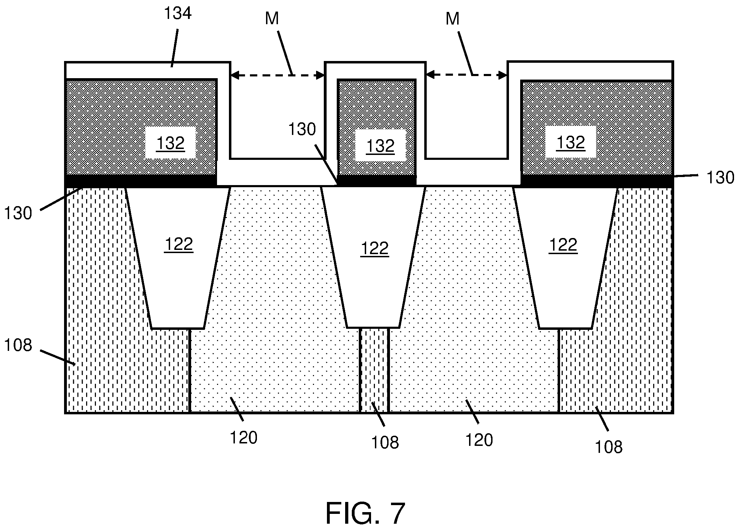

Referring to FIG. 7, continued processing may include forming second dielectric layer 134 on the upper surface and sidewalls first polycrystalline semiconductor layer 132, and on well regions 120. Second dielectric layer 134, as discussed herein, may include dielectric material(s) with a lower dielectric constant than first dielectric layer 130. In some examples, second dielectric layer 134 may have a similar or same composition as isolation structure(s) 122. Second dielectric layer 134 may be formed by conformal deposition, and thus various portions of second dielectric layer 134 may extend horizontally and/or vertically over doped regions 120 and/or layers 130, 132 based on the shape of their surfaces. The forming of second dielectric layer 134 by conformal deposition, and controlling the amount of dielectric material deposited, may prevent openings M from being completely filled by second dielectric layer 134.

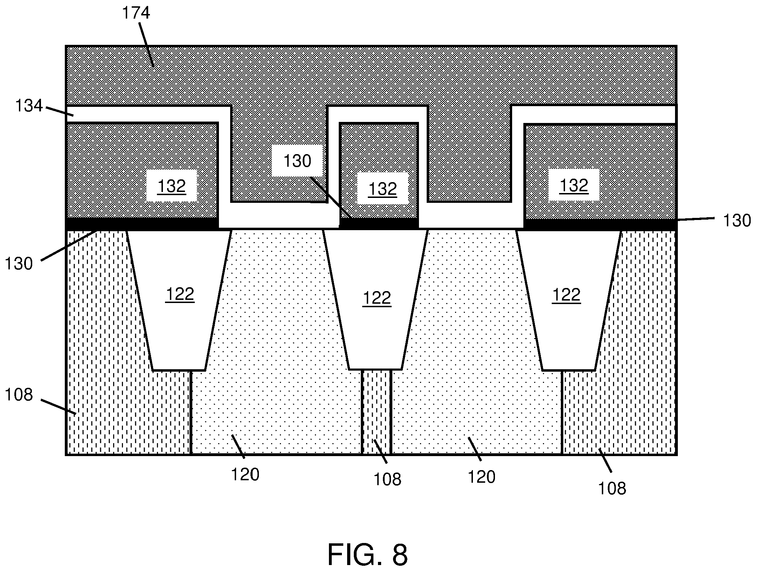

FIG. 8 illustrates filling the remaining space within openings M (FIGS. 5-7), and overlying space, with a second precursor polycrystalline semiconductor layer (simply "second precursor layer" hereafter) 174. Second precursor layer 174 may have a same or similar composition to that of first precursor layer 170 (FIG. 5) and polycrystalline semiconductor layers 132 formed therefrom. Second precursor layer 174 optionally may have different doping from layers 132, 170. Second precursor layer 174 may have a polycrystalline composition as a result of being formed on and in contact with dielectric materials and not on any other semiconductor materials located thereunder.

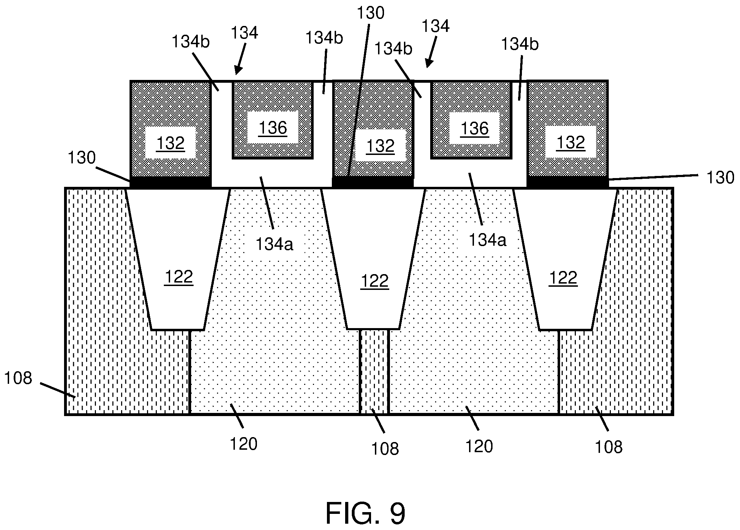

FIG. 9 depicts further processing my targeting and removing portions of second precursor layer 174 (FIG. 8), with any remaining portions of second precursor layer 174 becoming second polycrystalline semiconductor layer 136. Such processing may include first planarizing of second precursor layer 174, such as by chemical mechanical planarization (CMP). The planarization can be performed to a desired depth, e.g., to separate second precursor layer 174 into distinct regions adjacent second dielectric layer 134. The same planarizing of second precursor layer 174 can also remove portions of second dielectric layer 134 not located horizontally adjacent first polycrystalline semiconductor layers 132 or on well regions 120. Further processing may include, e.g., forming a temporary mask (not shown) on layers 132, 134, 136 with a desired horizontal width and removing all materials not covered by the mask from substrate 108.

Any materials not covered by the temporary mask may be removed, e.g., by vertical etching in the same manner shown in FIG. 6 and discussed elsewhere herein. Horizontally outer portions of substrate 108 are thus no longer covered by any of layers, 130, 132, 134, 136. In addition, second dielectric 134 exhibits first portions 134a extending horizontally over well regions 120 and second portions 134b extending vertically upward from first portions 134a. Moreover, the processes described herein to form layers 132, 134, 136 cause second polycrystalline semiconductor layers 136 to be located further above well region 120 than first polycrystalline semiconductor layers 132 above isolation structures 122.

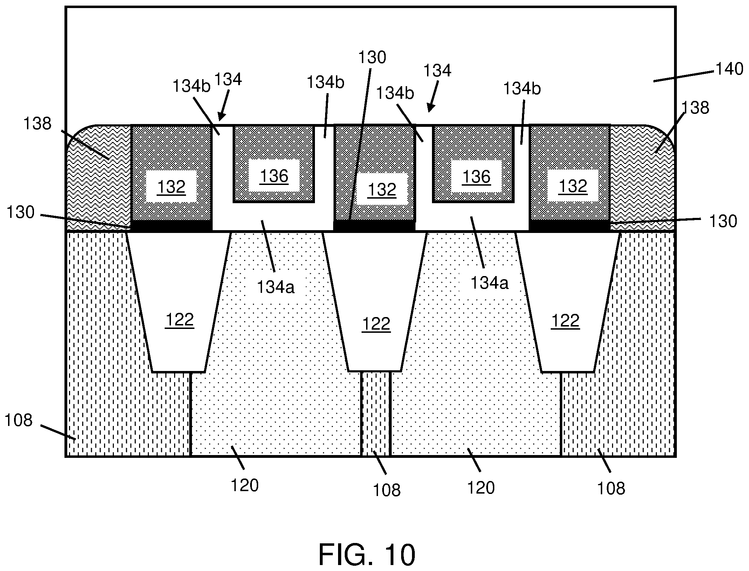

FIG. 10 depicts forming sidewall spacers 138 on sidewall surfaces of first polycrystalline semiconductor layers 132. In further examples, the horizontally outermost material(s) may include first dielectric layer 130, second dielectric layer 134 and/or second polycrystalline semiconductor layer 136, in which case sidewall spacers 138 may be horizontally adjacent any one or more of these components. However embodied, sidewall spacers 138 may be formed by conformal deposition of any desired dielectric material(s) and subsequent planarization and/or vertical etching, such that sidewall spacers 138 remain intact only alongside layer(s) 130, 132, 134, 136 on horizontally outer ends of materials over substrate 108. ILD 140 then can be formed, e.g., by depositing additional dielectric materials on the structure and other portions of substrate 108. ILD 140 may include any dielectric material configured for vertical separation of electrically active materials, and in an example, ILD 140 may have a same composition or similar composition to isolation structures 122 and/or second dielectric layer 134. Subsequent processing may include removing portions of ILD 140 (e.g., by masking, etching, deposition, etc.) to form contacts 142, 144 (FIGS. 1-4) and any metal wires and/or vias of metal wiring layer 104 (FIGS. 1-4) thereover.

Embodiments of the disclosure provide various technical and commercial advantages, examples of which are discussed herein. Among other things, structure 100 may provide improvements in capacitive density as compared to conventional capacitors formed only in metal wiring layers 104. Embodiments of structure 100 may provide a higher capacitance density than conventional capacitors, e.g., by providing capacitive junctions C1, C2 (FIG. 3) without requiring substantial active components within device layer 106, e.g., apart from doped regions 120. Moreover, the arrangements of active materials (e.g., polycrystalline semiconductor layers 132, 136) and dielectric materials (e.g., second dielectric layer 134 with multiple portions 134a, 134b) within structure 100 provide higher operational density than other types of capacitor structures. The presence of different capacitive junctions C1, C2 in different directions across one material (i.e., second dielectric layer 134) allows multiple capacitor devices to be formed by only depositing one layer of dielectric material. In addition to these and other technical benefits, embodiments of the disclosure are capable of providing robust alternating polarity metal-oxide-metal (APMOM) capacitor arrangements with additional capacitive junctions C1, C2 therein simply by forming metal wiring layers 104 and contacts 142, 144 over structure 100 in any desired arrangement.

The structure and method as described herein are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a," "an," and "the," are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, the disclosure relates to a semiconductor-based capacitor structure and method of forming the semiconductor-based capacitor. A structure according to the disclosure includes a semiconductor substrate including a well region. An isolation structure is in the semiconductor substrate laterally adjacent to the well region. A first dielectric layer is on the isolation structure. A first polycrystalline semiconductor layer is on the first dielectric layer. A second dielectric layer includes a first portion on the well region and at least one second portion extending vertically from the first portion. A second polycrystalline semiconductor layer is on the first portion of the second dielectric layer. The second portion of the second dielectric layer is laterally between and immediately adjacent to the second polycrystalline semiconductor layer and the first polycrystalline semiconductor layer.

The following embodiments are explicitly disclosed.

### Embodiment 1:

A structure comprising:
a semiconductor substrate including a well region;
an isolation structure in the semiconductor substrate laterally adjacent to the well region;
a first dielectric layer on the isolation structure;
a first polycrystalline semiconductor layer on the first dielectric layer;
a second dielectric layer including a first portion on the well region and at least one second portion extending vertically from the first portion; and
a second polycrystalline semiconductor layer on the first portion of the second dielectric layer, wherein the second portion of the second dielectric layer is laterally between and immediately adjacent to the second polycrystalline semiconductor layer and the first polycrystalline semiconductor layer.

### Embodiment 2:

The structure of embodiment 1, wherein the first dielectric layer is thinner than the second dielectric layer.

### Embodiment 3:

The structure of embodiment 1 or 2, wherein the first dielectric layer and the second dielectric layer include different dielectric materials.

### Embodiment 4:

The structure of one of embodiments 1 to 3, wherein the second dielectric layer includes two second portions and wherein the second polycrystalline semiconductor layer is on the first portion, laterally between and adjacent the two second portions.

### Embodiment 5:

The structure of one of embodiments 1 to 4, further comprising a sidewall spacer on the semiconductor substrate laterally adjacent the first dielectric layer and the first polycrystalline semiconductor layer. In some special illustrative examples herein, the first polycrystalline semiconductor layer may be between and adjacent to the sidewall spacer and the second portion of the second dielectric layer.

### Embodiment 6:

The structure of one of embodiments 1 to 5, further comprising a capacitor including a first electrode including the first polycrystalline semiconductor layer and the well region and a second electrode including the second polycrystalline semiconductor layer.

### Embodiment 7:

The structure of embodiment 6, further comprising:
a first contact to the first electrode at the well region of the semiconductor substrate; and
a second contact to second electrode the second polycrystalline semiconductor layer.

### Embodiment 8:

The structure of one of embodiments 1 to 7, further comprising:
at least one additional well region in the semiconductor substrate so as to provide a plurality of well regions in the semiconductor substrate;
at least one additional isolation structure in the semiconductor substrate so as to provide a plurality of isolation structures in the semiconductor substrate on opposing sides of at least one of the plurality of well regions;
wherein the plurality of isolation structures are provided such that, on each isolation structure, a respective first dielectric layer is formed on the isolation structure and a respective first polycrystalline semiconductor layer on the respective first dielectric layer, and
wherein the plurality of well regions are provided such that, on each well region, a respective second dielectric layer including a respective first portion on the well region and respective second portions extending vertically from the respective first portion and a respective second polycrystalline semiconductor layer on the respective first portion laterally between and adjacent to the respective second portions, wherein each respective second portion is further laterally between and adjacent one respective first polycrystalline semiconductor layer and one respective second polycrystalline semiconductor layer.

In some illustrative examples herein, the respective first dielectric layer on each well region may be thinner than the respective second dielectric layer, and/or
the respective first dielectric layer and the respective second dielectric layer on each well region may include different dielectric materials, and/or
the structure may further comprise a sidewall spacer on the semiconductor substrate laterally adjacent one of the first dielectric layers and one of the first polycrystalline semiconductor layers.

In some other illustrative examples herein, the structure may further comprise a capacitor including a first electrode including each first polycrystalline semiconductor layer and each well region, and a second electrode including each second polycrystalline semiconductor layer.

In some other illustrative examples herein, the structure may further comprise:
a first contact to the first electrode at the well region thereof; and
a second contact to second electrode the second polycrystalline semiconductor layer thereof.

In embodiment 8, the term "respective" may be synonymous to "dedicated" and both terms may be interchanged.

The structure of embodiment 8 adds at least one well region and at least one isolation structure to the well region and the isolation structure defined in any of embodiments 1 to 7 such that the structure of embodiment 8 comprises in total a plurality of well regions and a plurality of isolations structures. On each isolation structure of this plurality of isolation structures, a first dielectric layer on the isolation structure and a first polycrystalline semiconductor layer on the first dielectric layer. Accordingly, there is a plurality of first dielectric layers, each of which being associated with a respective one of the plurality of isolation structures. Similarly, there is a plurality of second dielectric layers, each of which being associated with a respective one of the well regions of the plurality of well regions such that a second dielectric layer of the plurality of second dielectric layers (each of which including a first portion and second portions extending vertically from the first portion and a second polycrystalline semiconductor layer on the first portion laterally between and adjacent to the second portions, wherein each second portion is further laterally between and adjacent one first polycrystalline semiconductor layer and one second polycrystalline semiconductor layer) is formed on each well region of the plurality of well regions.

### Embodiment 9:

A structure comprising:
a semiconductor substrate including a plurality of well regions;
a plurality of isolation structures in the semiconductor substrate on opposing sides of at least one of the plurality of well regions;
on each isolation structure, a first dielectric layer on the isolation structure and a first polycrystalline semiconductor layer on the first dielectric layer; and
on each well region, a second dielectric layer including a first portion on the well region and second portions extending vertically from the first portion and a second polycrystalline semiconductor layer on the first portion laterally between and adjacent to the second portions, wherein each second portion is further laterally between and adjacent one first polycrystalline semiconductor layer and one second polycrystalline semiconductor layer.

### Embodiment 10:

The structure of embodiment 10, wherein, on each well region, the first dielectric layer is thinner than the second dielectric layer.

### Embodiment 11:

The structure of embodiment 9 or 10, wherein, on each well region, the first dielectric layer and the second dielectric layer include different dielectric materials.

### Embodiment 12:

The structure of one of embodiments 9 to 11, further comprising a sidewall spacer on the semiconductor substrate laterally adjacent one of the first dielectric layers and one of the first polycrystalline semiconductor layers.

### Embodiment 13:

The structure of one of embodiments 9 to 12, further comprising a capacitor including a first electrode including each first polycrystalline semiconductor layer and each well region, and a second electrode including each second polycrystalline semiconductor layer.

### Embodiment 14:

The structure of embodiment 13, further comprising:
a first contact to the first electrode at the well region thereof; and
a second contact to second electrode the second polycrystalline semiconductor layer thereof.

### Embodiment 15:

A method comprising:
forming a well region in a semiconductor substrate;
forming an isolation structure in the semiconductor substrate laterally adjacent to the well region;
forming a first dielectric layer on the isolation structure;
forming a first polycrystalline semiconductor layer on the first dielectric layer;
forming a second dielectric layer including a first portion on the well region and at least one second portion extending vertically from the first portion; and
forming a second polycrystalline semiconductor layer on the first portion of the second dielectric layer, wherein the second portion of the second dielectric layer is positioned laterally between and immediately adjacent to the second polycrystalline semiconductor layer and the first polycrystalline semiconductor layer.

### Embodiment 16:

The method of embodiment 15, wherein the first dielectric layer is thinner than the second dielectric layer.

### Embodiment 17:

The method of embodiment 15 or 16, wherein the first dielectric layer and the second dielectric layer include different dielectric materials.

### Embodiment 18:

The method of one of embodiments 15 to 17, wherein forming the second dielectric layer includes forming two second portions and wherein the second polycrystalline semiconductor layer formed is on the first portion, laterally between and adjacent the two second portions.

### Embodiment 19:

The method of one of embodiments 15 to 18, further comprising forming a sidewall spacer on the semiconductor substrate laterally adjacent the first dielectric layer and the first polycrystalline semiconductor layer, wherein the first polycrystalline semiconductor layer is between and adjacent to the sidewall spacer and the second portion of the second dielectric layer.

### Embodiment 20:

The method of one of embodiments 15 to 19, further comprising forming a capacitor including a first electrode including the first polycrystalline semiconductor layer and the well region and a second electrode including the second polycrystalline semiconductor layer.

### Embodiment 21:

The method of embodiment 20, further comprising:
forming a first contact to the first electrode at the well region of the semiconductor substrate; and
forming a second contact to second electrode the second polycrystalline semiconductor layer.

### Embodiment 22:

The method of one of embodiments 15 to 21, wherein the structure of one of embodiments 1 to 14 is formed.

In some illustrative examples herein, the method may comprise:
forming a plurality of well regions in a semiconductor substrate including;
forming a plurality of isolation structures in the semiconductor substrate on opposing sides of at least one of the plurality of well regions;
forming a first dielectric layer on the isolation structure and a first polycrystalline semiconductor layer on the first dielectric layer on each isolation structure; and
forming, on each well region, a second dielectric layer including a first portion on the well region and second portions extending vertically from the first portion and a second polycrystalline semiconductor layer on the first portion laterally between and adjacent to the second portions, wherein each second portion is further laterally between and adjacent one first polycrystalline semiconductor layer and one second polycrystalline semiconductor layer.

In some more illustrative examples herein, the first dielectric layer on each well region may be formed thinner than the second dielectric layer.

In some more illustrative examples herein, the first dielectric layer and the second dielectric layer may include different dielectric materials on each well region.

In some more illustrative examples herein, the method may further comprise forming a sidewall spacer on the semiconductor substrate laterally adjacent one of the first dielectric layers and one of the first polycrystalline semiconductor layers.

In some more illustrative examples herein, the method may further comprise forming a capacitor including a first electrode including each first polycrystalline semiconductor layer and each well region, and a second electrode including each second polycrystalline semiconductor layer.

In some more illustrative examples herein, the method may further comprise:
forming a first contact to the first electrode at the well region thereof; and
forming a second contact to second electrode the second polycrystalline semiconductor layer thereof.

## Claims

1. A structure, comprising:
a semiconductor substrate including a well region;
an isolation structure in the semiconductor substrate laterally adjacent to the well region;
a first dielectric layer on the isolation structure;
a first polycrystalline semiconductor layer on the first dielectric layer;
a second dielectric layer including a first portion on the well region and at least one second portion extending vertically from the first portion; and
a second polycrystalline semiconductor layer on the first portion of the second dielectric layer, wherein the second portion of the second dielectric layer is laterally between and immediately adjacent to the second polycrystalline semiconductor layer and the first polycrystalline semiconductor layer.

2. The structure of claim 1, wherein the first dielectric layer is thinner than the second dielectric layer, and/or
wherein the first dielectric layer and the second dielectric layer include different dielectric materials, and/or
wherein the second dielectric layer includes two second portions and wherein the second polycrystalline semiconductor layer is on the first portion, laterally between and adjacent the two second portions.

3. The structure of claim 1 or 2, further comprising a sidewall spacer on the semiconductor substrate laterally adjacent the first dielectric layer and the first polycrystalline semiconductor layer, wherein the first polycrystalline semiconductor layer is between and adjacent to the sidewall spacer and the second portion of the second dielectric layer.

4. The structure of one of claims 1 to 3, further comprising a capacitor including a first electrode including the first polycrystalline semiconductor layer and the well region and a second electrode including the second polycrystalline semiconductor layer.

5. The structure of claim 4, further comprising:
a first contact to the first electrode at the well region of the semiconductor substrate; and
a second contact to second electrode the second polycrystalline semiconductor layer.

6. The structure of one of claims 1 to 5, further comprising:
at least one additional well region in the semiconductor substrate so as to provide a plurality of well regions in the semiconductor substrate;
at least one additional isolation structure in the semiconductor substrate so as to provide a plurality of isolation structures in the semiconductor substrate on opposing sides of at least one of the plurality of well regions;
wherein the plurality of isolation structures are provided such that, on each isolation structure, a respective first dielectric layer is formed on the isolation structure and a respective first polycrystalline semiconductor layer on the respective first dielectric layer, and
wherein the plurality of well regions are provided such that, on each well region, a respective second dielectric layer including a respective first portion on the well region and respective second portions extending vertically from the respective first portion and a respective second polycrystalline semiconductor layer on the respective first portion laterally between and adjacent to the respective second portions, wherein each respective second portion is further laterally between and adjacent one respective first polycrystalline semiconductor layer and one respective second polycrystalline semiconductor layer.

7. The structure of claim 6, wherein, on each well region, the respective first dielectric layer is thinner than the respective second dielectric layer, and/or
wherein, on each well region, the respective first dielectric layer and the respective second dielectric layer include different dielectric materials, and/or
wherein the structure further comprises a sidewall spacer on the semiconductor substrate laterally adjacent one of the first dielectric layers and one of the first polycrystalline semiconductor layers.

8. The structure of claim 6 or 7, further comprising a capacitor including a first electrode including each first polycrystalline semiconductor layer and each well region, and a second electrode including each second polycrystalline semiconductor layer.

9. The structure of claim 8, further comprising:
a first contact to the first electrode at the well region thereof; and
a second contact to second electrode the second polycrystalline semiconductor layer thereof.

10. A method, comprising:
forming a well region in a semiconductor substrate;
forming an isolation structure in the semiconductor substrate laterally adjacent to the well region;
forming a first dielectric layer on the isolation structure;
forming a first polycrystalline semiconductor layer on the first dielectric layer;
forming a second dielectric layer including a first portion on the well region and at least one second portion extending vertically from the first portion; and
forming a second polycrystalline semiconductor layer on the first portion of the second dielectric layer, wherein the second portion of the second dielectric layer is positioned laterally between and immediately adjacent to the second polycrystalline semiconductor layer and the first polycrystalline semiconductor layer.

11. The method of claim 10, wherein the first dielectric layer is thinner than the second dielectric layer, and/or
wherein the first dielectric layer and the second dielectric layer include different dielectric materials.

12. The method of claim 10 or 11, wherein forming the second dielectric layer includes forming two second portions and wherein the second polycrystalline semiconductor layer formed is on the first portion, laterally between and adjacent the two second portions.

13. The method of one of claims 10 to 12, further comprising forming a sidewall spacer on the semiconductor substrate laterally adjacent the first dielectric layer and the first polycrystalline semiconductor layer, wherein the first polycrystalline semiconductor layer is between and adjacent to the sidewall spacer and the second portion of the second dielectric layer.

14. The method of one of claims 10 to 13, further comprising forming a capacitor including a first electrode including the first polycrystalline semiconductor layer and the well region and a second electrode including the second polycrystalline semiconductor layer.

15. The method of claim 14, further comprising:
forming a first contact to the first electrode at the well region of the semiconductor substrate; and
forming a second contact to second electrode the second polycrystalline semiconductor layer.
